(19)

Europäisches
Patentamt

European
Patent Office

Office européen
des brevets

(11)     **EP 3 147 631 B1**

(12)                     **EUROPEAN PATENT SPECIFICATION**

(45) Date of publication and mention
of the grant of the patent:
**23.10.2019   Bulletin 2019/43**

(51) Int Cl.:
*G01D 5/14* *(2006.01)*        *G01R 33/06* *(2006.01)*
*G01R 33/00* *(2006.01)*

(21) Application number: **16185732.1**

(22) Date of filing: **25.08.2016**

(54) **360° MAGNETIC ROTARY POSITION SENSOR SYSTEM AND METHOD FOR CALCULATING HIGH PRECISION 360-DEGREES ABSOLUTE ANGLE OF A ROTATING BODY**

360-GRAD-MAGNETDREHPOSITIONSSYSTEM UND VERFAHREN ZUR BERECHNUNG EINES HOCHPRÄZISEN 360-GRAD-ABSOLUTDREHWINKELS EINES DREHKÖRPERS

SYSTÈME DE CAPTEUR DE POSITION ROTATIF MAGNÉTIQUE À 360 ° ET PROCÉDÉ DE CALCUL D'ANGLE ABSOLU À 360 DEGRÉS DE HAUTE PRÉCISION D'UN CORPS ROTATIF

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:   25.08.2015   **DE 102015114067**
25.08.2015   **DE 102015114069**

(43) Date of publication of application:
**29.03.2017   Bulletin 2017/13**

(73) Proprietor: **IDT Europe GmbH**
**01109 Dresden (DE)**

(72) Inventor: **Janisch, Josef**
**8262 Ilz (AT)**

(74) Representative: **Lippert Stachow Patentanwälte**
**Rechtsanwälte**
**Partnerschaft mbB**
**Krenkelstraße 3**
**01309 Dresden (DE)**

(56) References cited:
**EP-A2- 2 777 521          WO-A1-2009/060329**
**DE-A1- 10 017 061       DE-A1- 10 248 060**
**DE-U1-202014 103 355**

**Description**

The invention discloses a 360-degree magnetic rotary position sensor system and a method for calculating high precision 360-degrees absolute angle of a rotating body using the sensor system.

The contactless determination of the absolute rotational angle position or linear position of a moving body is needed because of their robustness and durability especially in sensors in the automotive industry, industrial automation, medical devices and consumer products.

Magnetic position sensing involves the use of a magnetic sensor to provide an indication of the angular position of a rotatable magnetic field. One existing type of magnetic field sensor is an anisotropic magneto-resistive (AMR) sensor. An AMR sensor may include resistive elements that are configured into one or more Wheatstone bridge configurations. Each of the resistive elements may have a resistance that varies according to the magnitude and/or direction of a magnetic field that is incident upon the respective resistive element. The Wheatstone bridge configuration may generate an output voltage value that is indicative of the change in resistance caused by the amplitude and direction of the magnetic field.

Some types of AMR devices are configured to generate a unique output voltage value for rotational angles of an incident magnetic field within a range of 180 degrees. For example, an AMR device may include two Wheatstone bridge configurations oriented 45 degrees in rotation from each other. The resistive elements within the Wheatstone bridge configurations may be formed from Perm-alloy material. In such examples, the resistance of each of the resistive elements may vary according to a $\cos^2(\theta)$ relationship where $\theta$ is the angle between the magnetic moment vector of the resistive element and the current flowing through the resistive element. Such an AMR device may be able to produce a first output voltage that varies according to a $\sin(2\theta)$ relationship and a second output voltage that varies according to a $\cos(2\theta)$ relationship. The first and second output voltages may be used to determine an angular position of a magnetic field incident on the AMR device. Because the $\sin(2\theta)$ function and the $\cos(2\theta)$ function are periodic functions each with a period of 180 degrees, such an AMR device is not able to provide a unique output voltage value for each rotational angle of an incident magnetic field within a range of 360 degrees.

In US 2012/0223699 A1 the detection of a rotation angle over 360° is carried out by means of an AMR sensor creating two phase shifted signals with a period of 180° and two Hall sensors, providing two phase shifted digital signals, each having a period of 360°. The AMR sensor signals are processed to create two 90 degree phase shifted rounded ramp functions. A detection logic uses the states of the Hall sensor signals to select one of the two ramp signals along with predefined added offsets to create a linear ramp function over 360°. The phase shift of the two Hall sensor signal must lie between approximately 70° and 110°. The disadvantages of this disclosure are that the position of the Hall sensors must be very precise, because phase shifts outside the range 70° < phase shift < 110° cause large errors as the signal processing logic will select a nonlinear portion of the rounded ramp signals, therefore the placement of the Hall sensors relative to the AMR sensor is critical. In order to achieve this phase shift, the Hall sensors must be assembled as two separate, external components. They are not integrated in the signal processing circuit. Furthermore, the signal processing is only in the analog domain. The output of the sensor is an analog, linear ramp.

In US 6,212,783 B1 and US 6,707,293 B2 as well as in DE 10 2006 060 808 A1 an AMR sensor is used to generate an angle signal with a period of 180° and a Hall sensor switch to distinguish between first half and second half of the rotation. This causes an ambiguity at 180° and 360°, when the Hall sensor output signal is zero, respectively at the rising and falling edge of the switch output. This combination of sensors cannot safely distinguish between an angle of 180° and an angle of 360°, for example when the Hall sensor transition positions are slightly shifted due to temperature or process variations.

As stated above, AMR sensors are a preferred technology selected for angle sensing applications requiring high precision. However, AMR sensors have a maximum angle detection range of 180°. There are many applications requiring an angle detection range up to 360°. Hence, Hall sensors are capable of detecting an angle range up to 360°, however they are less accurate than AMR sensors. Therefore a combination of both technologies, AMR and Hall, can provide a high precision, 360° angle sensor.

Although, the combination of using both AMR and Hall sensors for detecting a 360° angle range with high precision, however they have deficiencies either by not being able to safely distinguish between 180° and 360° angles or by requiring a precise positioning of the Hall sensors relative to the AMR sensors. Another embodiment provide only a linear ramp output, which is a disadvantage if a form of digital interface is required.

DE 100 17 061 A1 and DE 102 48 060 A1 disclose related magnetic rotary position sensor systems.

It is therefore the object of the invention to avoid the disadvantages known form the state of the art and to offer an apparatus and method that allow a much wider mechanical tolerance range in the placement of the Hall sensors relative to the AMR sensor and an improved or simplified signal processing as well as a cost reduction and simplification in the manufacturing process.

The object of the invention will be solved by a 360-degree magnetic rotary position sensor system comprising in combination an anisotropic magneto-resistive (AMR) sensor having a maximum of 180 degrees absolute angle range, a first and a second lateral Hall sensor, both having a maximum of 360 degrees absolute angle range, a signal processing circuit and a magnet with a rotation axis whereas the rotation axis is positioned above a center of the AMR sensor and intersects the AMR sensor perpendicular; the AMR sensor and the Hall sensors lay in one plane, whereas the AMR sensor has a zero angle measurement position and the first Hall sensor is placed relative to the zero angle measurement position in a range from 0° < phase shift < 90° counterclockwise and the second Hall sensor is placed relative to the zero angle measurement position in a range from 0° < phase shift < 90° clockwise, resulting in an angle between 0° and <180° defined between the first Hall sensor, an intersection point of the rotation axis with the AMR sensor and the second Hall sensor, whereas the signal processing is designed performable in analog and/or digital.

So, the phase shift can be any phase shift >0° and <90° for each Hall sensor relative to the AMR sensor phase namely the zero angle measurement position, resulting in >0° and <180° for both Hall sensors relative to one another. So, the placement of the Hall sensors is not critical, as long as the phase shift is within the proposed range. A symmetry between the Hall sensors in relation to the zero angle measurement position is not necessary or critical anyway as long as one Hall sensor has a relative phase shift >0° and <90° clockwise and the other one >0° and <90° counterclockwise. For example, one may have -40° and the other one + 30° phase shift. It is not necessary that both are exactly the same (e.g. one Hall sensor has -40° and the other one +40°. This would also work but is not mandatory.

The sensor system represents a high precision contactless magnetic angle sensor for an absolute angle range up to 360° by detecting the magnetic field of a magnet attached to a movable object, combining both anisotropic magneto-resistive (AMR) technology and Hall sensor technology. Anisotropic magneto-resistive technology (further referred to as AMR technology) provides very high precision with a typical non-linearity of 0.1° or better. Therefore a sensor based on AMR technology is used. The AMR sensor contains two full bridges, rotated by 45° from one another. These two bridges are further referred to as AMR sensor. While AMR technology provides superior precision, it only has a maximum absolute angle detection range of 180°. In order to achieve a maximum angle detection range of 360° with the same high precision and added safety, two additional sensors based on lateral Hall technology are implemented. The use of lateral Hall sensors further reduce the overall costs, because lateral Hall sensors can be manufactured at lower cost compared to vertical Hall sensors and they provide a non-ambiguous angle detection over 360°.

The arrangement of the Hall sensors relative to the AMR sensor allows a wide mechanical placement tolerance range, as the phase shift of the Hall sensors relative to one another and relative to the zero angle measurement position of the AMR sensor can vary over a wide range. This also provides several packaging options for the final sensor. By sensing all three axes of a rotating magnet (X-Y-Z), additional safety is implemented. Also an error detection is provided by introducing a plausibility check of the sensor input signals: Firstly, signal 1 measured by the AMR sensor with a period of 180° represents the X-axis magnetic field. Secondly, signal 2 measured by the AMR sensor with a period of 180° represents the Y-axis magnetic field. This signal is phase shifted by 90° electrical relative to signal 1. Thirdly, signal 3 is measured by the first Hall sensor with a period of 360° and represents the Z-axis magnetic field. This signal is phase shifted towards increasing angle values relative to the AMR sensor zero angle measurement position. Fourthly, signal 4 is measured by the second Hall sensor with a period of 360° representing also the Z-axis magnetic field, but signal 4 is phase shifted relative to signal 3, namely towards decreasing angle values relative to the AMR sensor zero angle measurement position. And by calculating the angle signal both as a continuous linear ramp over 360° from the Hall sensors as well as a continuous linear ramp over 180° from the AMR sensor the safety through redundant angle information can be implemented.

In one embodiment of the invention the AMR sensor, the Hall sensors and the signal processing circuit are integrated on one substrate. The substrate may be a surface mount package or other adequate forms of packaging the components in an easy to use form. It is possible to stack the AMR sensor on top of the signal processing circuit which is mounted on the common substrate. It is also possible to stack the AMR sensor on top of a Hall sensor signal processing unit to provide better density of the total assembly, allowing for a smaller substrate area.

In another embodiment of the invention the AMR sensor comprises two full bridges rotated by 45° from one another for detecting the horizontal components X and Y of a magnetic field generated by the rotating magnet. Each of the two bridges consists of four magneto-resistive elements arranged as a full bridge. The two bridges are mechanically rotated by 45° to provide two differential, 90° electrically phase shifted signals for further signal processing. The AMR sensor bridges are placed underneath the rotation axis, detecting the horizontal components (X and Y) of the magnetic field.

The Hall sensors are implemented around the rotation axis of the rotating magnet, detecting the vertical component (Z) of the magnetic field. The Hall sensor signals are phase shifted by 0° < phase shift < 180°. Calculating a continuous linear angle over 360° with two phase shifted input signals from the two lateral Hall sensors over a wide range of phase shift, the absolute angle of the magnet over 360° is determined. By combining absolute 360° information obtained from the two lateral Hall sensor output signals with the ≤ 180° angle information of the AMR sensor, a distinctive detection of the rotation angle over a full turn of 360° is achieved with high precision and added safety through redundant measurement of the magnet angle, as will be described later.

In one embodiment the signal processing circuit comprises a power management unit, a digital processing unit, a digital interface, an analog interface, and electrical components for analog-to-digital conversion as well as for performing a 360° angle sensing with high precision. It contains both integrated analog and digital components. For the signal processing the following general procedure can be applied: The signals of the first bridge of the AMR sensor are fed to a differential amplifier providing sensor signal 1. The signal 1 is further converted into a digital format by an analog to digital converter. The signals of the second bridge of the AMR sensor are fed to a differential amplifier providing sensor signal 2. This signal 2 is further converted into a digital format by an analog to digital converter. The digital signals of both analog to digital converters are then fed to the digital signal processing unit. By using separate analog to digital converters for parallel sampling of both signal channels 1 and 2, no delay is introduced between the samples, which might cause a phase delay error when a magnetic field signal is sampled from a fast rotating object. Therefore, this configuration is preferred for sensing objects running at high rotational speeds. Furthermore, signals 1 and 2 have a period of 180° rotation of the magnet. The first lateral Hall sensor is fed to a Hall Front End unit where offset compensation and amplification are performed, providing signal 3. This signal is further fed to analog to digital converter, creating a digital signal. Signal 3 has a period of 360° rotation of the magnet 300. It is phase shifted towards increasing angle values relative to the zero angle measurement position of the AMR sensor. The second lateral Hall sensor is fed to a Hall Front End unit where offset compensation and amplification are performed, providing signal 4. This signal is further fed to analog to digital converter, creating also a digital signal. Signal 4 has a period of 360° rotation of the magnet 300. It is phase shifted towards decreasing angle values relative to the zero angle measurement position of the AMR sensor. The converted digital signals of the two Hall sensors are fed to the digital signal processing unit. In the digital signal processing unit the angle of the rotating magnet is calculated for both the AMR sensor with a period of 180° as well as the Hall sensors with a period of 360°. The calculation result is then available through a digital interface or an analog interface. Possible forms of a digital interface include, but are not limited to Serial Peripheral Interface (SPI), SENT, $I^2C$®, PWM, ABI, UVW, SSI. A power management unit provides the necessary supply voltages for the analog and digital components in the signal processing circuit. Further, it provides the positive supply and the negative supply for the external AMR sensor bridges.

In a preferred embodiment the Hall sensors are integrated into the signal processing circuit. When integrating the two Hall sensors in the same silicon chip as the signal processing circuit, thus providing easier manufacturability and lower cost through integration.

In a preferred embodiment the two Hall sensors are positioned axially symmetrical to the zero angle position of the AMR sensor. And further preferred the phase shift is ±45°. The Switching point of 45° can be chosen as it lies exactly in the middle of the two extremes, >0° and <90°, providing the best separation of the switching points of the two signals provided by the two Hall sensors. Therefor it will be preferred to use 45°, but it is not mandatory. Any other phase shift combination between 0° and 90° counterclockwise and clockwise will be possible.

The object of the invention will also be solved by a method for calculating high precision 360-degrees absolute angle of a rotating body using the disclosed sensor system, whereas in a digital signal processing unit a first absolute angle is calculated with a period of 180 mechanical degrees provided by sensed signals of an AMR sensor and a second absolute angle is calculated with a period of 360 mechanical degrees provided by sensed signals of a first and a second Hall sensor, whereas also an intermediate digital signal is generated by the digital processing unit according to the calculated first and second absolute angle signals, which is high when the first calculated angle from the AMR sensor is < 180 electrical degree and which is low when the first calculated angle from the AMR sensor is ≥180 electrical degrees.

The object of the invention will also be solved by a method for calculating high precision 360-degrees absolute angle of a rotating body using the disclosed sensor system, whereas in a digital signal processing unit a first absolute angle is calculated with a period of 180 mechanical degrees provided by sensed signals of an AMR sensor and a second absolute angle is calculated with a period of 360 mechanical degrees provided by sensed signals of a first and a second Hall sensor, whereas also intermediate digital signals are generated by the digital processing unit according to the calculated first and second absolute angle signals.

The digital signal processing unit calculates two absolute angles, firstly, an absolute angle with a period of 180° from the AMR sensor. This is the primary sensor signal used for calculating the high precision 360° absolute angle signal, since AMR sensors provide a higher accuracy compared to Hall sensors. Secondly, an absolute angle with a period of 360° from the two lateral Hall sensors. This is the secondary sensor signal; it is used for redundancy and to determine the first and second 180° period from the AMR sensor signal over a full turn of 360°. Therefore, this signal may be distorted or have lower accuracy than the AMR sensor signal; the high accuracy 360° angle signal will still be maintained. In order to provide a redundant, non-ambiguous 360° angle signal from two 180° AMR angle sensor signals and two Hall sensor signals, the following input signals are required:

- An angle signal calculated from the AMR sensor signals of the two sensor bridge outputs, having a period of 180 mechanical degrees;
- An angle signal calculated from the Hall sensor signals of the two Hall sensors having a period of 360 mechanical degrees;

- These two mentioned signals are matched for common zero position through adding angle offsets to the calculated angles in the signal processing unit.

Therefore, the first AMR sensor bridge provides two signals of opposite value. The second AMR sensor bridge provides also two signals of opposite value. The differential signal 1 of the signals of the first sensor bridge and the differential signal 2 of the signals of the second sensor bridge are phase shifted by 90° electrical, providing sine and cosine shaped waveforms over a rotation of 180°. The digital signal processing unit performs an offset compensation and offset drift compensation over temperature of the AMR sensor signals 1 and 2. Offset and offset drift may be determined by empirical measurements at different temperatures. The user defined parameters for offset and offset drift over temperature may be stored in a non-volatile memory in the digital signal processing unit.

Further, the digital signal processing unit implements adequate forms of converting the sine 1 and cosine 2 shaped signals from the AMR sensor bridges into a linear representation through rectangular to polar coordinate transformation, such as an arctangent function or CORDIC algorithm. An absolute angle of the rotating magnet is obtained within a period of 180°. For a full turn of 360° the absolute position is calculated twice, once for 0° < angle ≤ 180° and once for 180° < angle ≤ 360°, with rotation in increasing angle values. The first Hall sensor provides a signal 3 which has a period of 360° and is phase shifted with increasing angle relative to the zero angle measurement position of the AMR sensor. The second Hall sensor provides a signal 4 which has a period of 360° and is phase shifted with decreasing angle relative to the zero angle measurement position of the AMR sensor. The Hall sensor signals 3 and 4 may have a phase shift of 0° < phase shift < 180° relative to one another. Therefore, the digital signal processing unit performs an offset and gain compensation of the Hall sensor signals 3 and 4. Further, the sum and the difference of signals 3 and 4 is calculated and normalized in order to obtain two 90° phase shifted sine and cosine signals. The offsets and gains may be determined by empirical measurements through rotating the magnet while collecting the raw data. The parameters for offsets and gains may be stored in a non-volatile memory in the digital processing unit. Further, the signal processing unit implements adequate forms of converting the obtained sine and cosine shaped signals from the normalized sum and difference of the Hall sensor signals 3 and 4 into a linear representation through rectangular to polar coordinate transformation, such as an arctangent function or CORDIC algorithm. An absolute angle of the rotating magnet is obtained within a period of 360°.

For calculating the high precision 360 degree absolute angle of a rotating body a first intermediate digital signal is high when the angle calculated from the AMR sensor is < 180 electrical degrees and which is low when the angle calculated from the AMR sensor is ≥ 180 electrical degrees. It should be noted that 360 electrical degrees from an AMR sensor angle signal are equal to 180 mechanical degrees. So, for AMR sensors, 1 mechanical degree = 2 electrical degrees.

Furthermore, a second intermediate digital signal is high when the calculated angle of the Hall sensor is + phase shift < calculated angle ≤ (180° + phase shift) mechanical degrees and is low at all other angle positions, whereas the phase shift is within the range of ±0° and ±90°. It should be noted that the exact switching positions of this signal are not critical. For Hall sensors the electrical degrees are the same as the mechanical degrees, 1 mechanical degree = 1 electrical degree. Therefore the term mechanical degree was chosen to be unambiguous.

And a third intermediate digital signal is low when the calculated angle of the Hall sensor is (180° - phase shift) < calculated angle ≤ (360° - phase shift) mechanical degrees and high at all other angle positions, whereas the phase shift is within the range of ±0° and ±90°. It should be noted that the exact switching positions of this signal are not critical.

In a preferred embodiment of the method for calculating high precision 360-degrees absolute angle of a rotating body, the high precision, absolute 360° signal is calculated by using the calculated angle signal of the AMR sensor as primary angle information and then adding 180° to the AMR sensor angle, depending on the generated intermediate digital signals. So, one can obtain the high precision 360-degrees absolute angle of a rotating body.

For a method for calculating high precision 360-degrees absolute angle of a rotating body the high precision, absolute 360° signal and the second calculated absolute angle signal of the Hall sensors are compared with each other by performing a safety redundancy check and if the signals do not match a warning of possible malfunction will be indicated. The safety redundancy check will be performed by sensing all three axes of a rotating magnet (X-Y-Z), additional safety is implemented; error detection is provided by introducing a plausibility check of the sensor input signals as follows: Firstly, signal 1 represents the X-axis magnetic field, measured by the AMR sensor with a period of 180°. Secondly, signal 2 represents the Y-axis magnetic field, measured by the AMR sensor with a period of 180°. This signal is phase shifted by 90° electrical relative to signal 1. Thirdly, signal 3 represents the Z-axis magnetic field, measured by the first Hall sensor with a period of 360°. This signal is phase shifted towards increasing angle values relative to the AMR sensor zero angle measurement position. Fourthly, signal 4 represents the Z-axis magnetic field, measured by the second Hall sensor with a period of 360°. Signal 4 is phase shifted relative to signal 3. This signal is phase shifted towards decreasing angle values relative to the AMR sensor zero angle measurement position. And fifthly, further safety through redundant angle information is implemented by calculating the angle signal both as a continuous linear ramp over 360° from the Hall sensors as well as a continuous linear ramp over 180° from the AMR sensor.

In order to calculate exact angle relations of a rotating body, a dynamic compensation of the phase offset as well as a dynamic phase offset error correction procedure should be implemented into the disclosed sensor system and method.

In order to calculate the angle by methods such as the arctangent function or a CORDIC algorithm, a phase shift of 90° between the sinusoidal inputs is required, providing

$$\text{signal 1 = A*sin(x)} \qquad\qquad (eq. 1)$$

$$\text{signal 2 = A*sin(x+90°) = A*cos(x)} \qquad\qquad (eq. 2)$$

where A represents the signal peak amplitude and x represents the angle $0...2\pi$, respectively $0...360°$. Sequential sampling of the two input signals from objects that are rotating while the samples are taken creates an additional phase shift offset. This offset depends on:

- the rotating speed and the rotating direction of the magnet
- the delay between measurements
- the sequence of sampling.

$$Phase\ offset = \frac{delay*360*speed*direction*sampling\ sequence}{60*10^6} \qquad (eq.\ 3),$$

where:

phase offset = phase shift offset caused by sequential sampling in degrees;
delay = sampling delay between the two input signals in microseconds
speed = rotation speed in revolutions per minute
direction = $\pm 1$, depending on clockwise or counterclockwise rotational direction
sampling = $\pm 1$, depending on the sequence of the sampled inputs (input 2 sampled after input 1 or vice versa)

As a result of this additional phase offset, the two input signals are no longer shifted by 90°

$$\text{signal 1 = A*sin(x)} \qquad\qquad (eq. 4)$$

$$\text{signal 2 = A*sin(x+90°±phase offset) <> A*cos(x)} \qquad (eq. 5)$$

Table 1 shows the rotational direction and sampling sequence:

| First sample, signal 1 at t=0 | Second sample, signal 2 at t=0+delay | Description |
|---|---|---|
| First sample is taken at position A | Second sample is taken at position B | Counterclockwise direction. After a delay, the magnet has advanced from Position A → A', the second sample is measured at an angle < 90° relative to the first sample. The measured phase shift between signals 1 and 2 = 90° - phase offset |

(continued)

| First sample, signal 1 at t=0 | Second sample, signal 2 at t=0+delay | Description |
|---|---|---|
| First sample is taken at position B | Second sample is taken at position A | Counterclockwise direction. After a delay, the magnet has advanced from Position B → B', the second sample is measured at an angle >90° relative to the first sample. The measured phase shift between signals 1 and 2 = 90° + phase offset |
| First sample is taken at position A | Second sample is taken at position B | Clockwise direction. After a delay, the magnet has advanced from Position A→ A", the second sample is measured at an angle >90° relative to the first sample. The measured phase shift between signals 1 and 2 = 90° + phase offset |
| First sample is taken at position B | Second sample is taken at position A | Clockwise direction. After a delay, the magnet has advanced from Position B→ B", the second sample is measured at an angle <90° relative to the first sample. The measured phase shift between signals 1 and 2 = 90° - phase offset |

As a result from the <>90° phase shift of the input signals an angle error is obtained with varying magnitude over the 0° to <360° angle range.

A <>90° phase shift between two input signals can be corrected to 90° by normalizing the sum an difference of the two input signals. Applying such a method for dynamic phase offset error correction requires that the amplitude of both sum and difference signals is constantly monitored and corrected if required as it changes with rotation speed. In an application where the movable target at which the magnetic source is mounted is constantly rotating, the monitoring of the sum and difference signal amplitudes may be established either by peak-to-peak detection of each signal period or by averaging the RMS (root mean square) value over each signal period or by other applicable means of signal level detection. Following the normalization of the 90° phase shifted sum and difference signals, an angle without errors resulting from phase offset can be calculated. Angle calculation may be performed by means of rectangular to polar coordinate transformation, such as arctan(x) function [10] or CORDIC algorithm. The calculated angle from the sum and difference is shifted relative to the sine input signal by a zero offset of:

$$zero - angle - position = \frac{phase\ offset}{2} \qquad (eq.\ 6)$$

The phase offset can be calculated from the ratio between sum and difference signals:

$$phase\ offset = 2 * \arctan\left(\frac{diff}{sum}\right) - 90°$$ (eq. 7)

phase offset    = phase shift offset caused by sequential sampling in degrees;
diff            = peak-to-peak or RMS amplitude of signal 1 - signal 2
sum             = peak-to-peak or RMS amplitude of signal 1 + signal 2

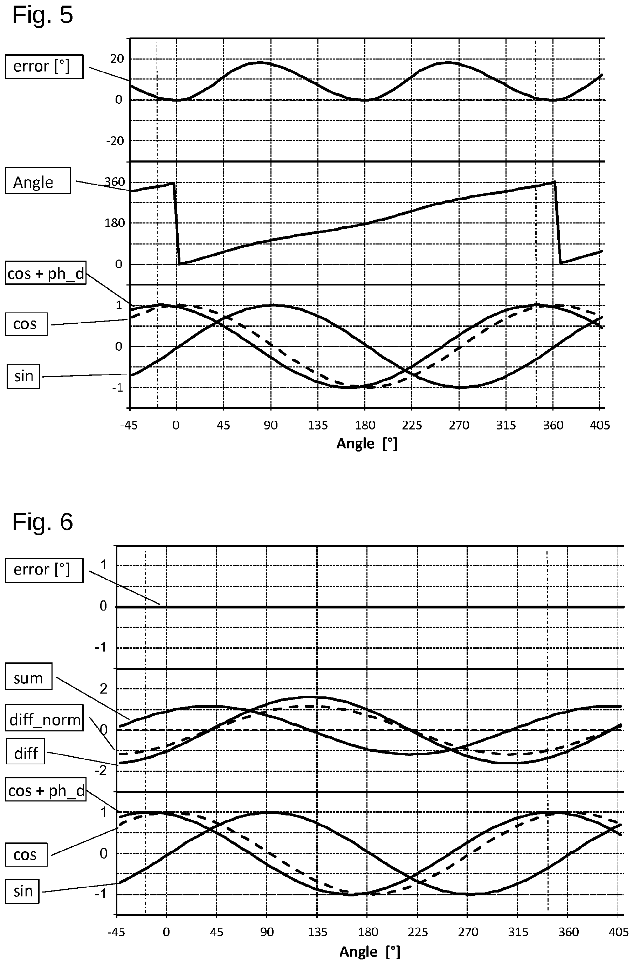

Figure 5 shows exemplary an error resulting from the phase offset. A rotational speed of 10.000 rpm with sequential sampling at a delay of 300 μs is assumed, causing a phase offset of 18°, applying eq.3. The cosine signal is shifted by 18 degrees relative to the sine signal, providing a total phase shift of 90° + 18° = 108° between the two input signals. The subsequent angle calculation based on the arctan(x) function creates a non-linearity of the calculated angle with an angle error up to ~18 degrees.

Figure 6 shows the error compensation through dynamic phase offset correction, assuming the same conditions as for figure 5. The sum (sin + (cos + phase delay)) and difference (sin - (cos + phase delay)) signals show different amplitudes, caused by the non-90° phase shift between them. The differential signal is then normalized to the same amplitude as the sum signal = diff_norm by multiplication with a constant factor:

$$multiplication\ factor = \frac{sum\ amplitude}{diff\ amplitude}$$ (eq. 8)

The amplitude ratio can also be calculated from the phase

delay: $$amplitude\ ratio = 1/\tan(\frac{90-phase\ offset}{2})$$ (eq. 9)

Following the normalization of the sum and differential signal, the angle can be calculated by means of rectangular to polar coordinate transformation, such as arctan(x) function of CORDIC algorithm:

$$angle = \arctan(\frac{normalized\ difference}{sum})$$ (eq. 10)

It should be noted that when using the arctan(x) function to create a linear function between 0...2π, respectively 0...360°, an angle offset of 180° must be added, when the sum is negative and an angle offset of 360° must be added when the normalized difference is negative while the sum is positive. Following the angle calculation, the zero angle position is corrected:

$$zero\ corrected\ angle = angle + \frac{90-phase\ offset}{2}$$ (eq. 11)

The remaining error from phase offset due to sequential sampling is zero. Applying this method allows phase offset error free sequential sampling of two input signals even when the magnet is rotating between the samples.

The invention is targeted to the field of contactless magnetic angular position sensing with high accuracy. It is combining anisotropic magnetoresistive (AMR) technology and Hall sensor technology to form a high precision 360° angle sensor with enhanced safety by redundant determination of the angular position through absolute angle determination over a period of 180° from an AMR sensor as well as absolute angle determination over a period of 360° from two lateral Hall sensors. AMR technology is used as the primary source of angle sensing as it provides high precision of typically 0.1° non-linearity or better. AMR sensors are sensitive to the X- and Y- in-plane magnetic field parallel to the sensor surface. A disadvantage of AMR sensors is that they can only detect a maximum angle range of 0...180°. Consequently, for detecting a full turn of an angular movement over 360°, additional information is required to distinguish between an angle of 0 < angle ≤ 180° and 180° < angle ≤ 360°. This distinction is given by introducing two integrated lateral Hall sensors. Lateral Hall sensors are sensitive to the Z-magnetic field perpendicular to the sensor surface. Hall sensors can also be used for 360° angle sensing, however in practice they do not provide the high accuracy achieved with AMR sensors. Therefore, a combination of AMR sensors for precise angle sensing and two Lateral Hall sensors for distinguishing the two half turns within a full turn angle movement were introduced.

The invention will be illustrated by means of embodiments. The corresponding drawings show

Fig. 1       An angle sensor with parallel sampling of the sensor signals;

Fig. 2       An Angle sensor with sequential sampling of the sensor signals;

Fig. 3       An Angle sensor with sequential and parallel sampling of AMR and Hall sensor signals;

Fig. 4       An Angle sensor with buffering and sequential sampling of the sensor signals;

Fig. 5       Error in angle determination resulting from phase offset;

Fig. 6       Error compensation through dynamic phase offset correction;

Fig. 7       AMR sensor differential signals;

Fig. 8       AMR sensor and Hall sensor signals and calculated angle signals;

Fig. 9       Composition of the High accuracy 360° absolute angle signal;

Fig. 10      Composition of the high accuracy 360° absolute angle signal with distorted Hall sensor signal;

Fig. 11      Assembly of AMR sensor and Signal processing Chip, side-by-side;

Fig. 12      Assembly of AMR sensor and signal processing chip, stacked assembly;

Fig. 13      Assembly of Angle sensor with separate Hall sensors;

Fig. 14      Side-by-Side Assembly of separate AMR and Hall signal processing units for extended redundancy;

Fig. 15      Stacked Assembly of separate AMR and Hall signal processing units for extended redundancy;

Fig. 16      AMR Sensor Signal Processing unit;

Fig. 17      Hall Sensor Signal Processing unit.

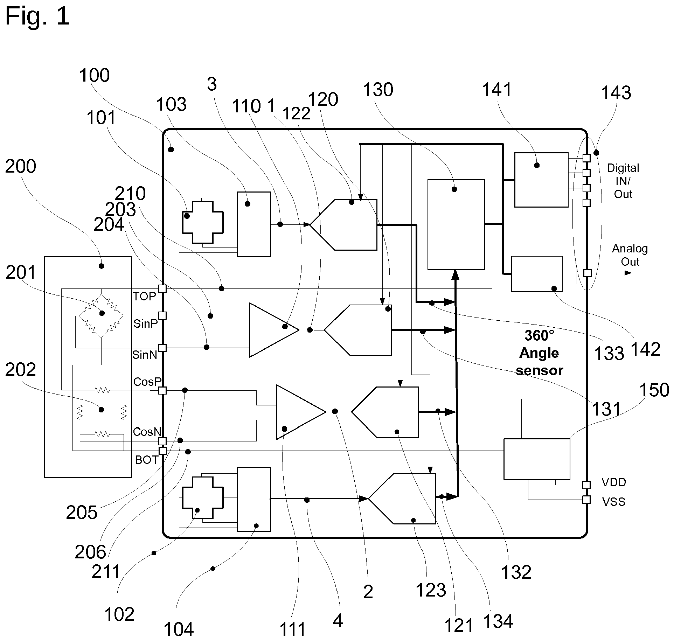

Figure 1 shows a 360 degrees magnetic rotary position sensor with parallel sampling of the sensor signals. The AMR Sensor 200 consists of two full bridges 201 and 202. Each of the two bridges 201 and 202 consists of four magneto-resistive elements arranged as a full bridge. The two bridges 201 and 202 are mechanically rotated by 45° to provide two differential, 90° electrically phase shifted signals 203, 204 and 205,206 for further signal processing. The signal processing unit contains all remaining electric components to perform a 360° angle sensing with high precision. It contains both integrated analog and digital components. The signals 203, 204 of the first bridge 201 are fed to a differential amplifier 110 providing sensor signal 1. Signal 1 is further converted into a digital format by an analog to digital converter 120. The signals 205, 206 of the second bridge 202 are fed to a differential amplifier 111 providing sensor signal 2. Signal 2 is further converted into a digital format by an analog to digital converter 121. The digital signals 131 and 132 of both analog to digital converters 120 and 121 are then fed to the digital signal processing unit 130. By using separate analog to digital converters for parallel sampling of both signal channels 1 and 2, no delay is introduced between the samples, which might cause a phase delay error when a magnetic field signal is sampled from a fast rotating object. Therefore, this configuration is preferred for sensing objects running at high rotational speeds. Signals 1 and 2 have a period of 180° rotation of the magnet 300. Lateral Hall sensor 101 is fed to a Hall Front End unit 103 where offset compensation and amplification are performed, providing signal 3. This signal is further fed to analog to digital converter 122, creating digital signal 133. Signal 3 has a period of 360° rotation of the magnet 300. It is phase shifted towards increasing angle values 7 relative to the AMR sensor 200. Lateral Hall sensor 102 is fed to a Hall Front End unit 104 where offset compensation and amplification are performed, providing signal 4. This signal is further fed to analog to digital converter 134, creating digital signal 134. Signal 4 has a period of 360° rotation of the magnet 300. It is phase shifted towards decreasing angle values 7 relative to the AMR sensor 200. The digital signals 133 and 134 are fed to the digital signal processing unit 130. In the digital signal processing in unit 130 the angle of the rotating magnet 300 is calculated for both the AMR sensor with a period of 180° as well as the Hall sensors with a period of 360°. The calculation result is then available through a digital interface 141 or an analog interface 142. Possible forms of a digital interface include, but are not limited to SPI, SENT, I²C®, PWM, ABI, UVW, SSI. A power management unit 150 provides the necessary supply voltages for the analog and digital components in the signal processing circuit 100. Further, it provides the positive supply 210 and the negative supply 211 for the external AMR sensor bridges 201, 202.

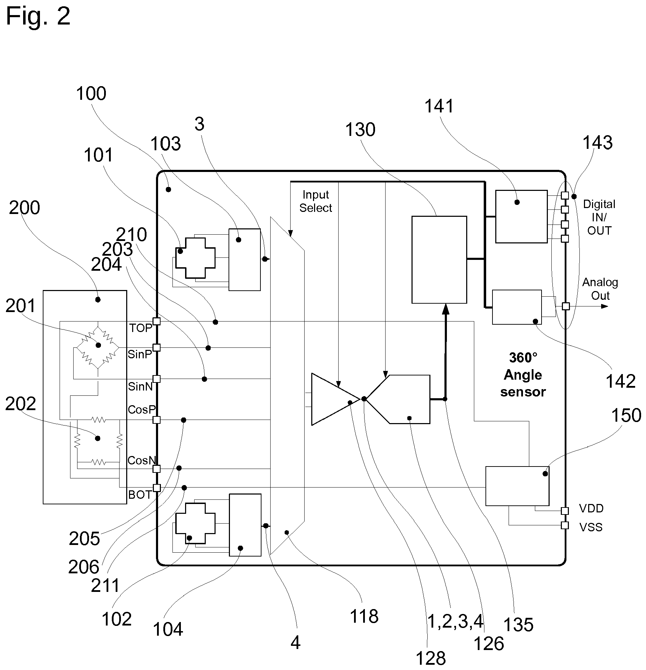

As shown in figure 2, the analog to digital conversion of the AMR sensor signals 203-204 and 205-206 as well as the Hall sensor signals 3 and 4 may also be shared with only one analog to digital converter 124. In this configuration, the AMR sensor signals 203 - 204 and 205 - 206 as well as the Hall sensor signals 3 and 4 are sequentially switched to the amplifier 128 input by a multiplexer 118 and then sequentially sampled by analog to digital converter 126. By using sequential sampling as shown in figure 2, only one analog to digital converter is used, which may reduce the cost of the total solution and provides improved linearity of the converted analog signals 1, 2, 3 and 4 as all signals are amplified with the same amplifier 128 and converted with the same analog to digital converter 126. The sequential sampling of the sensor input signals creates a phase delay when sampling magnetic fields of objects that are rotating at high speed. Therefore, the proposed arrangement shown in figure 2 is preferred for sensing slowly rotating or stationary objects. In addition, a method for dynamic compensation of the phase offset error caused by sequential sampling as described above in this document may be applied.

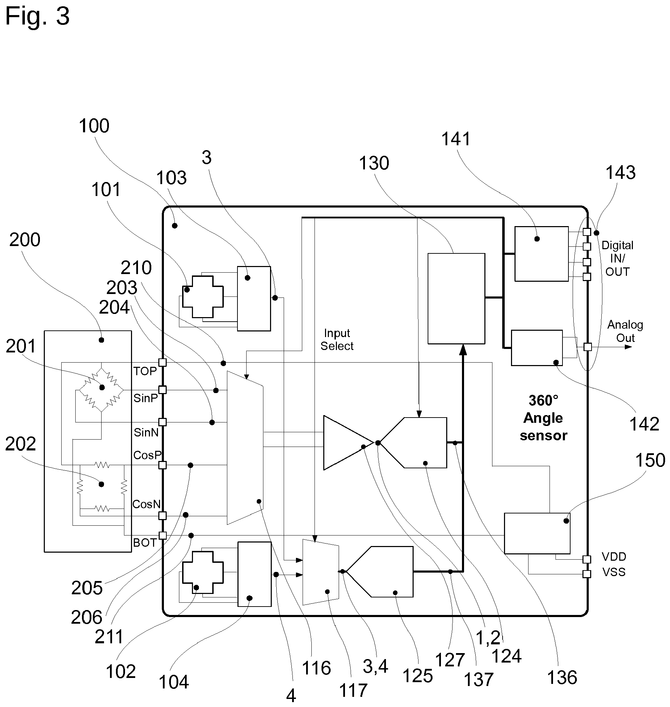

In another embodiment, a combination of sequential and parallel sampling of the sensor signals can be applied. In this embodiment, see figure 3, the AMR sensor signals 203,204 and 205,206 are sequentially sampled and then converted to digital format with analog to digital converter 124. Likewise, the Hall sensor signals 3 and 4 are sequentially sampled and then converted to digital format with a second analog to digital converter 125. This embodiment provides a smaller phase offset and faster sampling rate compared to the embodiment shown in figure 2 as only two signals are sequentially sampled instead of four. In addition, a method for dynamic compensation of the phase offset error caused by sequential sampling as described above in this document may be applied.

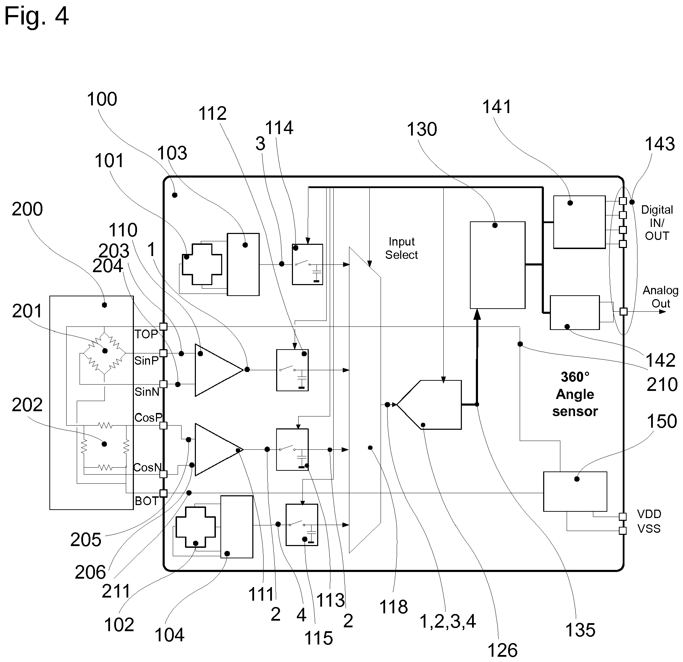

In another embodiment, see figure 4, the AMR sensor signals 1, 2 and the Hall sensor signals 3, 4 are temporarily stored in sample & hold circuits 112,113, 114,115 before they are sampled sequentially by multiplexer 118 and then converted to digital format by analog to digital converter 126. The benefit of this circuit is that both AMR sensor signals 1 and 2 as well as the Hall sensor signals 3 and 4 are captured at the same time in parallel before they are sampled sequentially. This way, no error from phase shift occurs when sampling magnetic fields of objects that are rotating at high speed.

Figure 5 shows exemplary an error resulting from the phase offset. A rotational speed of 10.000 rpm with sequential sampling at a delay of 300μs is assumed, causing a phase offset of 18°, applying eq.3. The cosine signal is shifted by 18 degrees relative to the sine signal, providing a total phase shift of 90° + 18° = 108° between the two input signals. The subsequent angle calculation based on the arctan(x) function creates a non-linearity of the calculated angle with an angle error up to ~18 degrees.

Figure 6 shows the error compensation through dynamic phase offset correction, assuming the same conditions as for figure 5. The sum (sin + (cos + phase delay)) and difference (sin - (cos + phase delay)) signals show different amplitudes, caused by the non-90° phase shift between them. The differential signal is then normalized to the same amplitude as the sum signal = diff_norm by multiplication with a constant factor:

$$multiplication\ factor = \frac{sum\ amplitude}{diff\ amplitude} \quad (\text{eq. } 8)$$

The amplitude ratio can also be calculated from the phase delay:

$$amplitude\ ratio = 1/\tan(\frac{90 - phase\ offset}{2}) \quad (\text{eq. } 9)$$

Following the normalization of the sum and differential signal, the angle can be calculated by means of rectangular to polar coordinate transformation, such as arctan(x) function of CORDIC algorithm:

$$angle = \arctan(\frac{normalized\ difference}{sum}) \quad (\text{eq. } 10)$$

It should be noted that when using the arctan(x) function to create a linear function between 0...2π, respectively 0...360°, an angle offset of 180° must be added, when the sum is negative and an angle offset of 360° must be added when the normalized difference is negative while the sum is positive. Following the angle calculation, the zero angle position is corrected:

$$zero\ corrected\ angle = angle + \frac{90 - phase\ offset}{2} \qquad (eq.\ 11)$$

The remaining error from phase offset due to sequential sampling is zero. Applying this method allows phase offset error free sequential sampling of two input signals even when the magnet is rotating between the samples. Hereinafter, the sensor signals provided by the AMR sensor, especially by the two bridges and the Hall sensors will be described in greater detail.

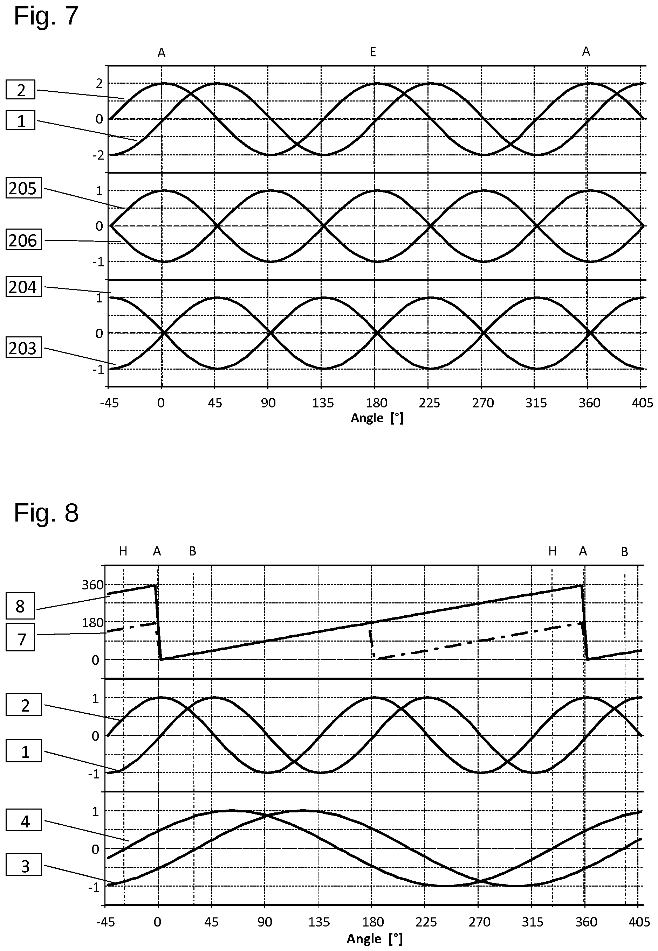

Figure 7 shows the sensor signals according to the embodiment shown in figure 1 to 4 at the output of the said sensors. AMR sensor bridge 201 provides two signals 203 and 204 of opposite value. AMR sensor bridge 202 provides two signals 205 and 206 of opposite value. The differential signal 1 of signals 203-204 and the differential signal 2 of signals 205 and 206 are phase shifted by 90° electrical, providing sine and cosine shaped waveforms over a rotation of 180°.

Digital signal processing unit 130 performs an offset compensation and offset drift compensation over temperature of the AMR sensor signals 1 and 2. Offset and offset drift may be determined by empirical measurements at different temperatures. The user defined parameters for offset and offset drift over temperature may be stored in a non-volatile memory in the digital processing unit 130. Further, signal processing unit 130 implements adequate forms of converting the sine 1 and cosine 2 shaped signals from the AMR sensor bridges 201 and 202 into a linear representation 7 through rectangular to polar coordinate transformation, such as an arctangent function or CORDIC algorithm, shown in figure 8.

An absolute angle of the rotating magnet 300 is obtained within a period of 180°. For a full turn of 360° the absolute position is calculated twice, once for 0° < angle ≤180°, depicted as the angle range from φ(A→E) and once for 180° < angle ≤360°, depicted as the angle range from φ(E→A) with rotation in increasing angle values.

Hall sensor 101 provides a signal 3 which has a period of 360° and is phase shifted with increasing angle relative to the 0° AMR Angle position 7. Hall sensor 102 provides a signal 4 which has a period of 360° and is phase shifted with decreasing angle relative to the 0° AMR Angle position 7. Hall sensor signals 3 and 4 may have a phase shift of 0° < phase shift < 180° relative to one another. Digital signal processing unit 130 performs an offset and gain compensation of the Hall sensor signals 3 and 4. Further, the sum and the difference of signals 3 and 4 is calculated and normalized in order to obtain two 90° phase shifted sine and cosine signals, see figure 8. Offsets and gains may be determined by empirical measurements through rotating the magnet while collecting the raw data. The parameters for offsets and gains may be stored in a non-volatile memory in the digital processing unit 130. Further, signal processing unit 130 implements adequate forms of converting the obtained sine and cosine shaped signals from the normalized sum and difference of the Hall sensor signals 3 and 4 into a linear representation 8 through rectangular to polar coordinate transformation, such as an arctangent function or CORDIC algorithm. An absolute angle of the rotating magnet 300 is obtained within a period of 360°.

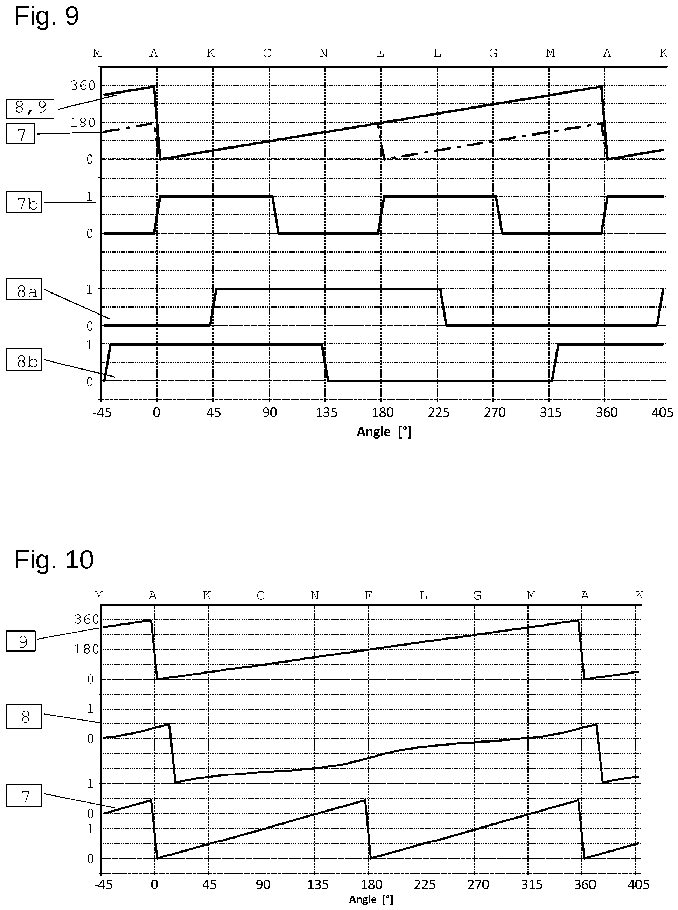

Referring now to figures 9 and 10 and Table 2:
The digital signal processing unit 130 calculates two absolute angles; First an absolute angle 7 with a period of 180° from the AMR sensor 200. This is the primary sensor signal used for calculating the high precision 360° absolute angle signal 9, since AMR sensors provide a higher accuracy compared to Hall sensors. Second an absolute angle 8 with a period of 360° from the two lateral Hall sensors 101 and 102. This is the secondary sensor signal; it is used for redundancy and to determine the first and second 180° period from the AMR sensor signal over a full turn of 360°. Therefore, this signal may be distorted or have lower accuracy than the AMR sensor signal 7; the high accuracy 360° angle signal 9 will still be maintained.

In order to provide a redundant, non-ambiguous 360° angle signal 9 from two 180° AMR angle sensor signals 1, 2 and two Hall sensor signals 3, 4, the following input signals are required:

- An angle signal 7 calculated from the AMR sensor signals 1 and 2, having a period of 180 mechanical degrees;
- An angle signal 8 calculated from the Hall sensor signals 3 and 4 having a period of 360 mechanical degrees;
- Signals 7 and 8 are matched for common zero position through adding angle offsets to the calculated angles in the signal processing unit 130;
- An intermediate digital signal 7b, which is high when the angle calculated from the AMR sensor is < 180 electrical degrees at angles φ(A→C), φ(E→G), and which is low when the angle calculated from the AMR sensor is >= 180 electrical degrees at angles φ(C→E), φ(G→A). It should be noted that 360 electrical degrees from an AMR sensor angle signal are equal to 180 mechanical degrees.
- An intermediate signal 8a which is high when the Hall sensor angle is 45° < Hall sensor angle ≤ 225° at angles φ(K→L) and low at all other angle positions. It should be noted that the exact switching positions of this signal are not critical.

- An intermediate signal 8b which is low when the Hall sensor angle is 135° < Hall sensor angle ≤ 315° at angles φ(M→N) and high at all other angle positions. It should be noted that the exact switching positions of this signal are not critical.

The high precision, absolute 360° signal 9 is then calculated by using the AMR sensor angle 7 as primary angle information and then adding 180° to the AMR sensor angle, depending on the intermediate signals 7b, 8a and 8b according to a truth table 2:

Table 2:

| Angle | Example, Figure Rotation angle of magnet | Imputs | | | | Output | |
|---|---|---|---|---|---|---|---|
| | | I/M signal 8a | I/M signal 8b | Intermediate signal 7b AMR angle < 180° Y/N? | AMR Angle 7 | Formula to create a 360° signal 9 | 360° angle Calculation result 9 |
| A→K | 0° - 45° | 0 | 1 | 1 | 0°-60° | AMR angle /2 | 0° - 30° |
| K→N | 45° - 135° | 1 | 1 | Don't care | 60°-300° | AMR angle /2 | 30° - 150° |
| N→E | 135° - 180° | 1 | 0 | 0 | 300°-360° | AMR angle /2 | 150° - 180° |
| E→L | 180° - 225°. | 1 | 0 | 1 | 0°-60° | 180° + AMR angle /2 | 180° - 210° |
| L→M | 225° - 315° | 0 | 0 | Don't care | 60°-300° | 180° + AMR angle /2 | 210° - 330° |
| M→A | 315° - 360° | 0 | 1 | 0 | 300°-360° | 180° + AMR angle /2 | 330° - 360° |

In figure 9 both the AMR sensor signal 7 and the Hall sensor signal 8 show a good linearity. The reconstructed high accuracy 360° angle signal 9 is identical with the Hall sensor output signal 8. A safety redundancy check by comparison of signals 8 and 9 would show no error between the two signals 8 and 9.

Table 2 and 3 show an example thereby that a rotation of the magnet over a full turn of 360° is depicted along with the corresponding sensor signals at various angles. Table 3 shows the sensor output signals in counterclockwise rotation with increasing angle values, whereas table 4 shows the sensor output signals in clockwise rotation with decreasing angle values:

Table 3:

| Position | Magnet angle | AMR sensor Angle 7 | Intermediate signal 8a | Intermediate signal 8b | Intermediate Signal 7b | Truth table | Calculated Angle 9 |
|---|---|---|---|---|---|---|---|
| A | 0° | 0° | 0 | 1 | 1 | AMR/2 | 0° |
| K | 44,999° | 89,99° | 0 | 1 | 1 | AMR/2 | 44,999° |
| | 45 | 90° | 1 | 1 | 1 | AMR/2 | 45 |
| C | 89.999° | 179,99° | 1 | 1 | 1 | AMR/2 | 89,999° |
| | 90° | 180° | 1 | 1 | 0 | AMR/2 | 90° |
| N | 134,999° | 269.99° | 1 | 1 | 0 | AMR /2 | 134,999° |
| | 135° | 270° | 1 | 0 | 0 | AMR/2 | 135° |
| E | 179,999° | 359,99° | 1 | 0 | 0 | AMR/2 | 179,999° |
| | 180° | 0° | 1 | 0 | 1 | 180+AMR /2 | 180° |

(continued)

| Position | Magnet angle | AMR sensor Angle 7 | Intermediate signal 8a | Intermediate signal 8b | Intermediate Signal 7b | Truth table | Calculated Angle 9 |
|---|---|---|---|---|---|---|---|
| L | 224,999° | 89,99° | 1 | 0 | 1 | 180+AMR /2 | 224,999° |
|  | 225° | 90° | 0 | 0 | 1 | 180+AMR /2 | 225° |
| G | 269,999° | 179,99° | 0 | 0 | 1 | 180+AMR /2 | 269,999° |
|  | 270° | 180° | 0 | 0 | 0 | 180+AMR /2 | 270° |
| M | 314,999° | 269.99° | 0 | 0 | 0 | 180+AMR /2 | 314,999° |
|  | 315° | 270° | 0 | 1 | 0 | 180+AMR /2 | 315° |
| A | 359,999° | 359,99° | 0 | 1 | 0 | 180+AMR /2 | 359,999° |

Table 4:

| Position | Magnet angle | AMR sensor Angle 7 | Intermediate signal 8a | Intermediate signal 8b | Intermediate Signal 7b | Truth table | Calculated Angle 9 |
|---|---|---|---|---|---|---|---|
| A | 0° | 0° | 0 | 1 | 1 | AMR /2 | 0° |
|  | 359,999° | 359,99° | 0 | 1 | 0 | 180+AMR /2 | 359,99 |
| M | 315° | 270° | 0 | 1 | 0 | 180+AMR /2 | 315° |
|  | 314,999° | 269,99° | 0 | 0 | 0 | 180+AMR /2 | 314,999° |
| G | 270° | 180° | 0 | 0 | 0 | 180+AMR /2 | 270° |
|  | 269,999° | 179,99! | 0 | 0 | 1 | 180+AMR /2 | 269,999° |
| L | 225° | 90° | 0 | 0 | 1 | 180+AMR /2 | 225° |
|  | 224,999° | 89,99° | 1 | 0 | 1 | 180+AMR /2 | 224,999° |
| E | 180° | 0° | 1 | 0 | 1 | 180+AMR /2 | 180° |
|  | 179,999° | 359,99° | 1 | 0 | 0 | AMR /2 | 179,99° |
| N | 135° | 270° | 1 | 0 | 0 | AMR /2 | 135° |
|  | 134,999° | 269,99° | 1 | 1 | 0 | AMR /2 | 134,999° |
| C | 90° | 180° | 1 | 1 | 0 | AMR /2 | 90° |
|  | 89,999° | 179,99° | 1 | 1 | 1 | AMR /2 | 89,999° |

(continued)

| Position | Magnet angle | AMR sensor Angle 7 | Intermediate signal 8a | Intermediate signal 8b | Intermediate Signal 7b | Truth table | Calculated Angle 9 |
|---|---|---|---|---|---|---|---|
| K | 45 | 90° | 1 | 1 | 1 | AMR /2 | 45 |
| | 44,999° | 89,99° | 0 | 1 | 1 | AMR /2 | 44,999° |

In figure 10 an example is shown where the Hall sensor signal 8 is shifted in the zero angle position relative to the AMR sensor angle position 7 and in addition has a large non-linearity due to phase, offset or gain matching errors at the input signals 3 and 4. As shown, the reconstructed 360° high accuracy signal 9 shows no distortion, as it is reconstructed from the high accuracy AMR sensor signal 7. A safety redundancy check by comparison of signals 8 and 9 would show a nonlinearity error between the two signals 8 and 9, indicating a warning of possible malfunction. However, the high accuracy 360° signal 9 would remain intact and undistorted.

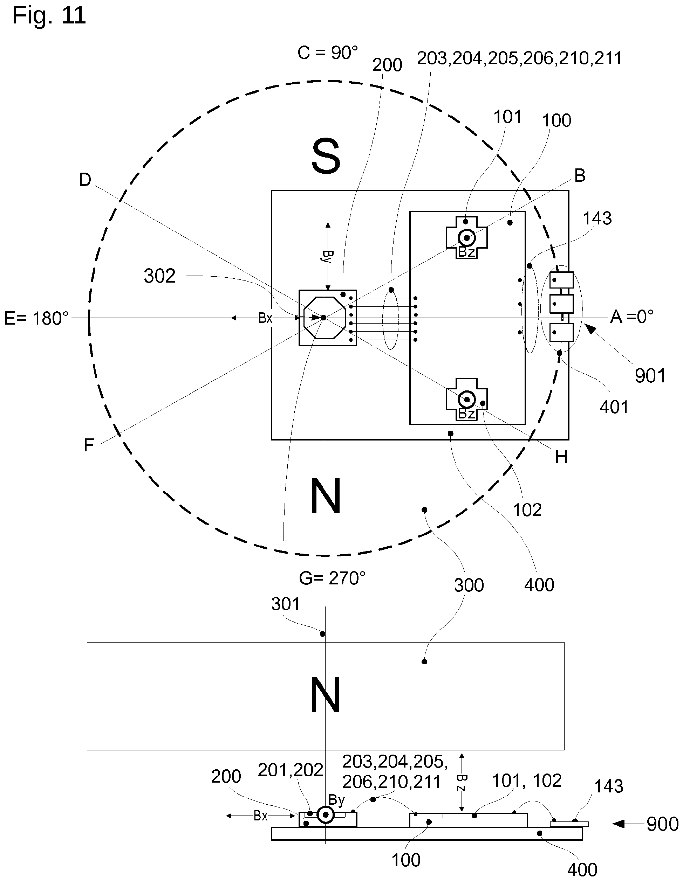

Figure 11 shows a possible embodiment of the sensor and magnet arrangement. The signal conditioning or processing circuit 100 and the AMR sensor 200 are mounted on a common substrate 400. Substrate 400 may be a surface mount package or other adequate forms of packaging the components in an easy to use form. The electrical connection between the AMR sensor 200 and the signal processing circuit 100 may be established through chip-to-chip wire bonding. The connection between the signal conditioning circuit 100 and electrical connections 143 may be established through wire bonding from circuit 100 to the package lead frame 401. Magnet 300 is mounted such that the rotational axis 301 is centered above the center of AMR Sensor 200. The calculated angle 7 of the AMR sensor 200 is set to result in an angle of 0° this magnet position shown in figure 11. Hall sensors 101 and 102 are electrically connected such that a south pole of a magnet 300 generates a negative Hall sensor output voltage and a north pole of a magnet 300 creates a positive Hall sensor output voltage. Hall sensor 101 is placed at an angle B-A relative to the 0° position of the AMR sensor. Hall sensor 102 is placed at an angle H-A relative to the zero angle position of the AMR sensor 200. At angle 0°, as shown in figure 11, the angle measured by the AMR sensor is 0°. Hall sensor 101 is shifted towards the south pole of magnet 300 and creates a negative output voltage 3. Hall sensor 102 is shifted towards the north pole of magnet 300 and creates a positive output voltage 4.

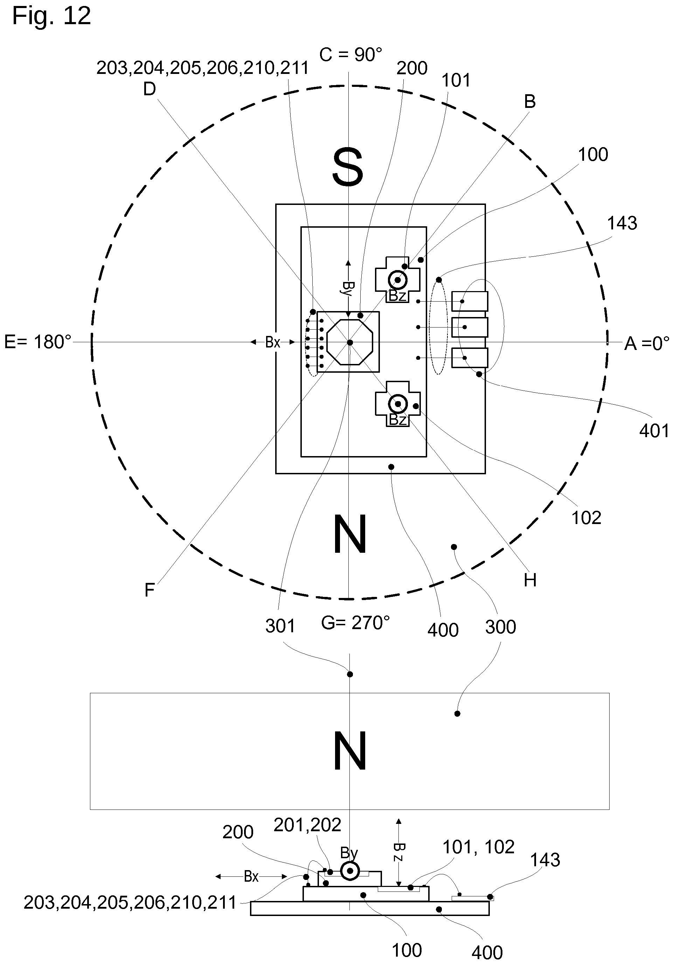

Figure 12 shows another possible embodiment of the sensor and magnet arrangement. The AMR sensor 200 is stacked on top of the signal processing circuit 100. The signal processing circuit 100 with the AMR sensor 200 stacked on top are mounted on a common substrate 400. Substrate 400 may be a surface mount package or other adequate forms of packaging the components in an easy to use form. The electrical connection between the AMR sensor 200 and the signal conditioning circuit 100 may be established through chip-to-chip wire bonding. The connection between the signal conditioning circuit 100 and electrical connections 143 may be established through wire bonding from circuit 100 to the package lead frame 401. Magnet 300 is centered above the center of AMR Sensor 200. The calculated angle of the AMR sensor 200 is set to result in an angle of 0° this magnet position shown in figure 11. Hall sensors 101 and 102 are electrically connected such that a south pole of a magnet 300 generates a negative Hall sensor output voltage and a north pole of a magnet 300 creates a positive Hall sensor output voltage. Hall sensor 101 is placed at an angle $\varphi(A{\rightarrow}B)$ relative to the 0° position, also called zero angle measurement position, of the AMR sensor 200. Hall sensor 102 is placed at an angle $\varphi(A{\rightarrow}H)$ relative to the 0° position of the AMR sensor 200. At angle 0°, as shown in figure 12, the angle measured by the AMR sensor is 0°. Hall sensor 101 is shifted towards the south pole of magnet 300 and creates a negative output voltage 3. Hall sensor 102 is shifted towards the north pole of magnet 300 and creates a positive output voltage 4.

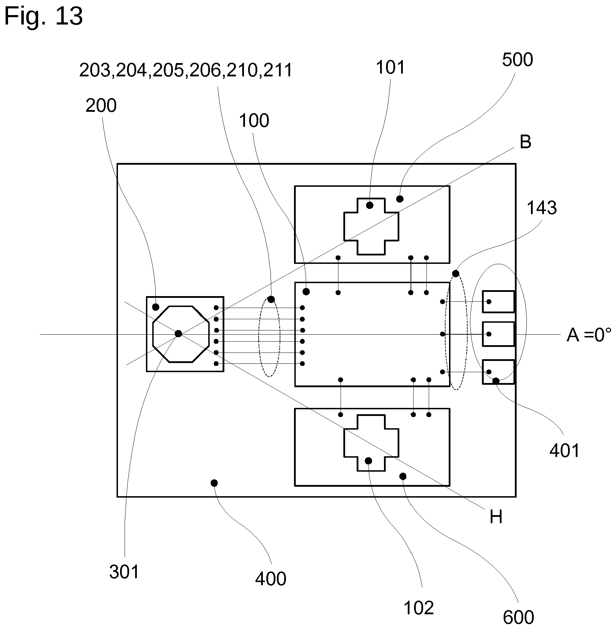

Figure 13 shows another possible embodiment of the sensor and magnet arrangement. The Hall sensors 101 and 102 are placed as separate components to signal processing unit 100. Hall Sensor 101 is embedded in circuit 500 and Hall sensor 102 is embedded in circuit 600. Both circuits 500 and 600 are electrically connected to signal processing unit 100.

Hall sensor 101 is placed at an angle $\varphi(A{\rightarrow}B)$ relative to the 0° position of the AMR sensor 200. Hall sensor 102 is placed at an angle $\varphi(A{\rightarrow}H)$ relative to the 0° position of the AMR sensor 200.

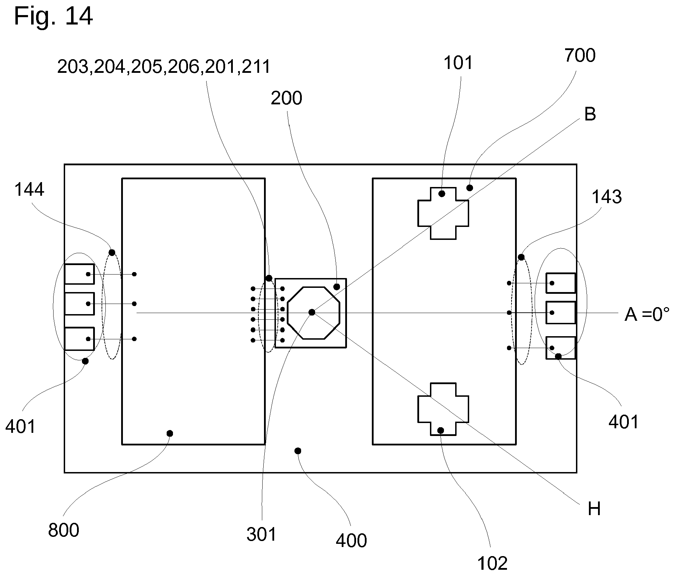

Referring to figures 14 to 17: Additional safety may be provided by physically separating the sensor signal processing for the AMR sensor 200 and the sensor signal processing for the Hall sensors 101, 102. A malfunction of one signal processor would not affect the other, providing extended redundancy of the signal processing.

Shown in figure 14 is an embodiment where the signal processing is split into circuit 700 for processing the Hall sensor signals and circuit 800 for processing the AMR sensor signals. Circuit 700 may be implementing a circuit which provides 360° angle information from the Hall sensors 101, 102, available at the analog and/or digital interface 143. Circuit 800 provides 180° angle information from the AMR sensor 200, available at the analog and/or digital interface 144. Reconstruction of a high precision 360° angle information must be performed in an external digital signal processing unit, according to the truth table shown in Table 1.

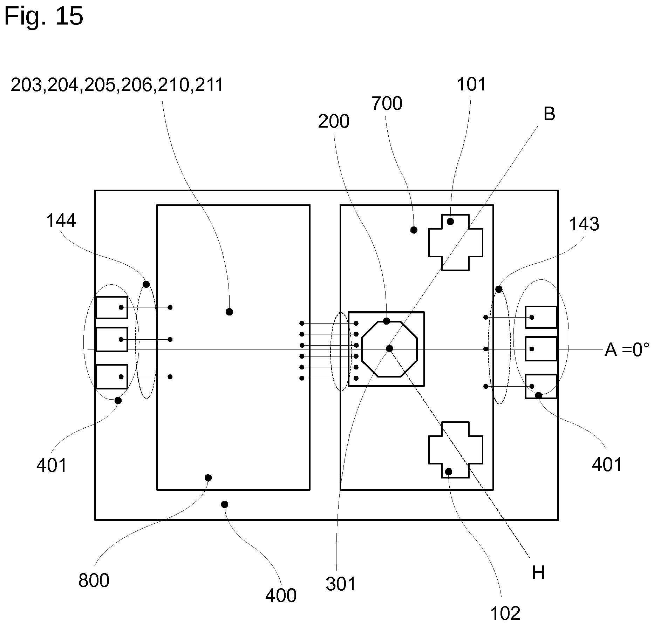

In figure 15 an embodiment is shown where the AMR sensor 200 is stacked on top of the Hall sensor signal processing unit to provide better density of the total assembly, allowing for a smaller substrate area 400. In this assembly, the angle φ(B→H) from the rotation axis 301, which is over the center of AMR sensor 200, and the center of the Hall sensors 101,102 must be smaller than 180° to ensure proper processing of the Hall sensor signals.

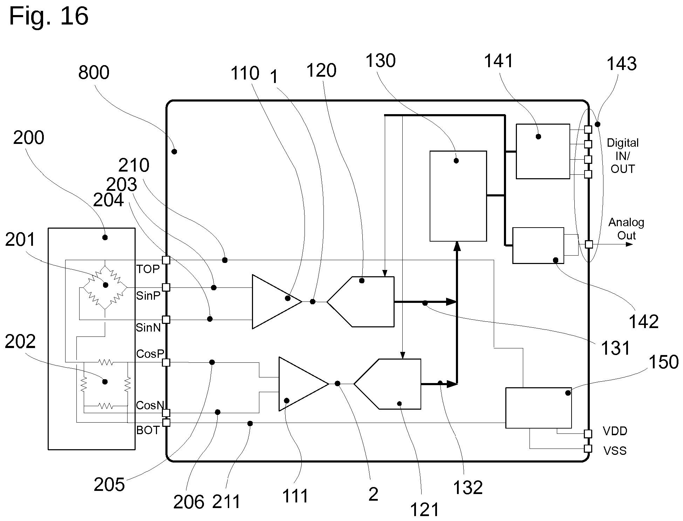

Figure 16 shows an embodiment which contains only the sensor signal processing unit for the AMR sensor 200. Other embodiments with parallel or sequential sampling as well as combinations thereof as shown in figure 1, figure 2, figure 3 or figure 4 may also be applied.

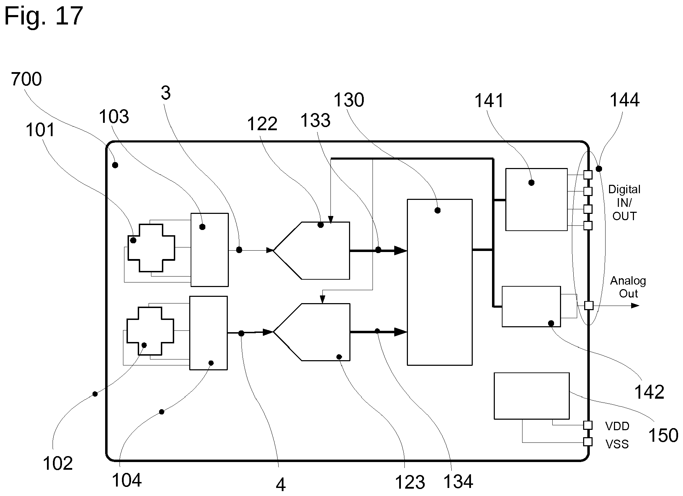

Figure 17 shows an embodiment which contains only the sensor signal processing unit for the Hall sensors 101,102. Other embodiments with parallel or sequential sampling as well as combinations thereof as shown in figure 1, figure 2, figure 3 or figure 4 may also be applied.

Reference signs

| | |
|---|---|
| 1 | AMR Signal Sin |
| 2 | AMR Signal Cos |
| 3 | Hall Signal 1 |
| 4 | Hall Signal 2 |
| 5 | Hall sensor 1 digital comparator signal |
| 6 | Hall sensor 2 digital comparator signal |
| 7 | AMR 180° angle signal |
| 8 | Hall 360° angle signal |
| 9 | reconstructed 360° angle signal |
| 100 | signal processing unit |
| 101 | Hall sensor 1 |
| 102 | Hall sensor 2 |
| 103 | Hall Front End 1 |
| 104 | Hall Front End 2 |
| 105 | Comparator / Schmitt-Trigger for Hall sensor 1 |
| 106 | Comparator / Schmitt-Trigger for Hall sensor 2 |
| 110 | Differential Amplifier for AMR sensor 201 |
| 111 | Differential Amplifier for AMR sensor 202 |
| 112 | Sample & Hold Circuit for AMR sin signal |
| 113 | Sample & Hold Circuit for AMR cos signal |
| 114 | Sample & Hold Circuit for Hall sensor 1 signal |
| 115 | Sample & Hold Circuit for Hall sensor 2 signal |
| 116 | 2-1 Mux AMR sensor |
| 117 | 2-1 Mux Hall sensors |
| 118 | 4-1 Mux AMR + Hall sensors |
| 120 | Analog to digital converter 1 |
| 121 | Analog to digital converter 2 |
| 122 | Analog to digital converter 3 |
| 123 | Analog to digital converter 4 |
| 124 | Analog to digital converter 2-1 AMR MUX |
| 125 | Analog to digital converter 2-1 Hall MUX |
| 126 | Analog to digital converter 4-1 Hall MUX |
| 127 | 2-1 AMR Multiplexer differential amplifier |
| 128 | 4-1 AMR Multiplexer differential amplifier |
| 130 | Digital Signal processing unit |
| 131 | AMR Sin sensor digital signal |
| 132 | AMR Cos sensor digital signal |
| 133 | Hall sensor1 digital signal |
| 134 | Hall sensor2 digital signal |
| 135 | 4-1 Mux digital signal |
| 136 | 2-1 Mux AMR sensor digital signal |

137     2-1 Mux Hall sensor digital signal
141     Digital Interface
142     Analog Interface
143     Analog/Digital interface connections
144     Interface connections from unit 700
150     Power Management unit
200     AMR Sensor
201     AMR sin bridge sensor
202     AMR cos bridge sensor
203     AMR Sensor SinP signal
204     AMR Sensor SinN signal
205     AMR Sensor CosP signal
206     AMR Sensor CosN signal
210     AMR Sensor positive supply
211     AMR Sensor negative supply
300     Magnet
301     Rotation Axis
302     intersection point
400     Substrate
401     Substrate connections
500     external Hall sensor 1
600     external Hall sensor 2
700     Hall Sensor signal processing unit
800     AMR Sensor signal processing
900     plane
901     zero angle measurement position

**Claims**

1. A 360-degree magnetic rotary position sensor system comprising in combination an AMR sensor (200) having a maximum of 180 degrees absolute angle range, a first and a second lateral Hall sensor (101, 102), both providing a non-ambiguous angle direction over 360 degrees absolute angle range, a signal processing circuit (100) and a magnet (300) providing a magnetic field with three components (X-Y-Z) and with a rotation axis (301) whereas the rotation axis (301) is positioned above a center of the AMR sensor (200) and intersects the AMR sensor (200) perpendicular; the AMR sensor (200) and the Hall sensors (101, 102) lay in one plane (900), whereas the AMR sensor (200) has a zero angle measurement position (901) indicating a signal value of zero and detecting the horizontal components X and Y of the magnetic field and the first Hall sensor (101) is placed relative to the zero angle measurement position (901) in a range from 0° < phase shift < 90° counterclockwise measuring a signal which is phase shifted with increasing angle relative to the zero angle measurement position of the AMR sensor and the second Hall sensor (102) is placed relative to the zero angle measurement position (901) in a range from 0° < phase shift < 90° clockwise measuring a signal which is phase shifted with decreasing angle relative to the zero angle measurement position of the AMR sensor, resulting in an angle between 0° and < 180° defined between the first Hall sensor (101), an intersection point (302) of the rotation axis (301) with the AMR sensor (200) and the second Hall sensor (102), whereas the signal processing is designed performable in analog and/or digital and whereas an error detection is provided by using the sensor system signals of the AMR sensor and the two Hall sensors.

2. The sensor system according to claim 1, wherein the AMR sensor (200), the Hall sensors (101, 102) and the signal processing circuit (100) are integrated on one substrate (400) .

3. The sensor system according to claim 1, wherein the AMR sensor (200) comprises two full bridges (201, 202) rotated by 45° from one another for detecting the horizontal components X and Y of a magnetic field generated by the rotating magnet.

4. The sensor system according to claim 1, wherein the Hall sensors (101, 102) are implemented around the rotation axis (301) of the rotating magnet (300) for detecting a vertical component Z of a magnetic field generated by the rotating magnet (300).

5. The sensor system according to claim 2, wherein the Hall sensors (101, 102) are integrated into the signal processing circuit (100).

6. The sensor system according to claim 1, wherein the two Hall sensors (101, 102) are positioned axially symmetrical to the zero angle position (901) of the AMR sensor (200).

7. The sensor system according to claim 1, wherein the phase shift is $\pm 45°$.

8. Method for calculating high precision 360-degrees absolute angle of a rotating body using the sensor system according to claims 1 to 7, whereas in a digital signal processing unit (130) a first absolute angle is calculated by an arctangent function with a period of 180 mechanical degrees provided by sensed signals (7) of an AMR sensor (200) which have a phase shift of 90° to each other and a second absolute angle is calculated with a period of 360 mechanical degrees provided by sensed signals (8) of a first and a second Hall sensor (101, 102), whereas intermediate digital signals (7b, 8a, 8b) are generated by the digital processing unit (130) according to the calculated first and second absolute angle signals (7, 8, 9), whereas an error detection is performed by calculating the angle signal both as a continuous linear ramp over 360° from the Hall sensors as well as a continuous linear ramp over 180° from the AMR sensor.

9. Method for calculating high precision 360-degrees absolute angle of a rotating body according to claim 8, wherein a first intermediate digital signal (7b) is high when the angle calculated from the AMR sensor (200) is < 180 electrical degrees and which is low when the angle calculated from the AMR sensor (200) is $\geq$ 180 electrical degrees.

10. Method for calculating high precision 360-degrees absolute angle of a rotating body according to claim 8, wherein a second intermediate digital signal (8a) is high when the calculated angle of the Hall sensor is 0° + phase shift < calculated angle $\leq$ (180° + phase shift) mechanical degrees and is low at all other angle positions, whereas the phase shift is within the range of $\pm 0°$ and $\pm 90°$.

11. Method for calculating high precision 360-degrees absolute angle of a rotating body according to claim 8, wherein a third intermediate digital signal (8b) is low when the calculated angle of the Hall sensor is (180° - phase shift) < calculated angle $\leq$ (360° - phase shift) mechanical degrees and high at all other angle positions, whereas the phase shift is within the range of $\pm 0°$ and $\pm 90°$.

12. Method for calculating high precision 360-degrees absolute angle of a rotating body according to claims 8 to 11, wherein the high precision, absolute 360° signal is calculated by using the calculated angle signal of the AMR sensor (200) as primary angle information and then adding 180° to the AMR sensor angle, depending on the generated intermediate digital signals.

**Patentansprüche**

1. 360-Grad-Magnet-Drehpositions-Sensorsystem, das in Kombination einen AMR-Sensor (200) mit einem Absolutwinkelbereich von maximal 180 Grad, einen ersten und einen zweiten seitlichen Hallsensor (101, 102), die beide eine eindeutige Winkelrichtung über einen 360-Grad-Absolutwinkelbereich bereitstellen, eine Signalverarbeitungsschaltung (100) und einen Magnet (300) umfasst, der ein Magnetfeld mit drei Komponenten (X-Y-Z) und mit einer Drehachse (301) bereitstellt, wobei die Drehachse (301) über einer Mitte des AMR-Sensors (200) positioniert ist und den AMR-Sensor (200) senkrecht schneidet, der AMR-Sensor (200) und die Hallsensoren (101, 102) in einer Ebene (900) liegen, wobei der AMR-Sensor (200) eine Nullwinkel-Messposition (901) aufweist, die einen Signalwert von Null angibt und die horizontalen Komponenten X und Y des Magnetfelds erkennt,
und der erste Hallsensor (101) relativ zu der Nullwinkel-Messposition (901) in einem Bereich von 0° < Phasenverschiebung < 90° entgegen dem Uhrzeigersinn platziert ist und ein Signal misst, das mit zunehmendem Winkel relativ zu der Nullwinkel-Messposition des AMR-Sensors phasenverschoben wird,
und der zweite Hallsensor (102) relativ zu der Nullwinkel-Messposition (901) in einem Bereich von 0° < Phasenverschiebung < 90° im Uhrzeigersinn platziert ist und ein Signal misst, das mit abnehmendem Winkel relativ zu der Nullwinkel-Messposition des AMR-Sensors phasenverschoben wird,
was in einem Winkel zwischen 0° und < 180° resultiert, der zwischen dem ersten Hallsensor (101), einem Schnittpunkt (302) der Drehachse (301) mit dem AMR-Sensor (200) und dem zweiten Hallsensor (102) definiert ist,
wobei die Signalverarbeitung analog und/oder digital durchführbar konzipiert ist, und wobei eine Fehlererkennung durch Verwenden der Sensorsystemsignale des AMR-Sensors und der beiden Hallsensoren bereitgestellt wird.

**2.** Sensorsystem gemäß Anspruch 1, wobei der AMR-Sensor (200), die Hallsensoren (101, 102) und die Signalverarbeitungsschaltung (100) auf einem Substrat (400) integriert sind.

**3.** Sensorsystem gemäß Anspruch 1, wobei der AMR-Sensor (200) zwei volle Brücken (201, 202) umfasst, die um 45° gegeneinander gedreht werden, um die horizontalen Komponenten X und Y eines von dem Drehmagneten erzeugten Magnetfelds zu erkennen.

**4.** Sensorsystem gemäß Anspruch 1, wobei die Hallsensoren (101, 102) um die Drehachse (301) des Drehmagneten (300) implementiert sind, um eine vertikale Komponente Z eines von dem Drehmagneten (300) erzeugten Magnetfelds zu erkennen.

**5.** Sensorsystem gemäß Anspruch 2, wobei die Hallsensoren (101, 102) in die Signalverarbeitungsschaltung (100) integriert sind.

**6.** Sensorsystem gemäß Anspruch 1, wobei die beiden Hallsensoren (101, 102) axial symmetrisch zu der Nullwinkelposition (901) des AMR-Sensors (200) positioniert sind.

**7.** Sensorsystem gemäß Anspruch 1, wobei die Phasenverschiebung $\pm 45°$ beträgt.

**8.** Verfahren zum Berechnen eines hochpräzisen 360-Grad-Absolutwinkels eines Drehkörpers unter Verwendung des Sensorsystems gemäß den Ansprüchen 1 bis 7,
wobei, in einer Digitalsignal-Verarbeitungseinheit (130), ein erster Absolutwinkel durch eine Arcustangensfunktion mit einer Periode von 180 mechanischen Grad, bereitgestellt durch erfasste Signale (7) eines AMR-Sensors (200), die eine Phasenverschiebung von 90° zueinander haben, berechnet wird,
und ein zweiter Absolutwinkel mit einer Periode von 360 mechanischen Grad, bereitgestellt durch erfasste Signale (8) eines ersten und eines zweiten Hallsensors (101, 102) berechnet wird,
wobei digitale Zwischensignale (7b, 8a, 8b) gemäß den berechneten ersten und zweiten Absolutwinkelsignalen (7, 8, 9) durch die digitale Verarbeitungseinheit (130) erzeugt werden,
wobei eine Fehlererkennung durch Berechnen des Winkelsignals sowohl als eine kontinuierliche lineare Rampe über 360° von den Hallsensoren als auch als eine kontinuierliche lineare Rampe über 180° von dem AMR-Sensor durchgeführt wird.

**9.** Verfahren zum Berechnen eines hochpräzisen 360-Grad-Absolutwinkels eines Drehkörpers gemäß Anspruch 8, wobei ein erstes digitales Zwischensignal (7b) hoch ist, wenn der von dem AMR-Sensor (200) berechnete Winkel < 180 elektrische Grad ist, und das niedrig ist, wenn der von dem AMR-Sensor (200) berechnete Winkel $\geq$ 180 elektrische Grad ist.

**10.** Verfahren zum Berechnen eines hochpräzisen 360-Grad-Absolutwinkels eines Drehkörpers gemäß Anspruch 8, wobei ein zweites digitales Zwischensignal (8a) hoch ist, wenn der berechnete Winkel des Hallsensors 0° + Phasenverschiebung < berechneter Winkel $\leq$ (180° + Phasenverschiebung) mechanische Grad ist, und bei allen anderen Winkelpositionen niedrig ist, wobei die Phasenverschiebung innerhalb des Bereiches von $\pm 0°$ bis $\pm 90°$ liegt.

**11.** Verfahren zum Berechnen eines hochpräzisen 360-Grad-Absolutwinkels eines Drehkörpers gemäß Anspruch 8, wobei ein drittes digitales Zwischensignal (8b) niedrig ist, wenn der berechnete Winkel des Hallsensors (180° - Phasenverschiebung) < berechneter Winkel $\leq$ (360° - Phasenverschiebung) mechanische Grad ist, und bei allen anderen Winkelpositionen hoch ist, wobei die Phasenverschiebung innerhalb des Bereiches von $\pm 0°$ bis $\pm 90°$ liegt.

**12.** Verfahren zum Berechnen eines hochpräzisen 360-Grad-Absolutwinkels eines Drehkörpers gemäß den Ansprüchen 8 bis 11, wobei das hochpräzise, absolute 360°-Signal durch Verwenden des berechneten Winkelsignals des AMR-Sensors (200) als primäre Winkelinformation und dann Hinzufügen von 180° zu dem Winkel des AMR-Sensors abhängig von den erzeugten digitalen Zwischensignalen berechnet wird.

**Revendications**

**1.** Système de capteurs de position rotatifs magnétiques à 360 degrés, comprenant en combinaison un capteur AMR (200) présentant un maximum de 180 degrés de plage d'angle absolue, un premier et un deuxième capteur à effet Hall latéral (101, 102), fournissant tous les deux une direction d'angle non ambiguë sur 360 degrés de plage d'angle absolue, un circuit de traitement de signal (100) et un aimant (300) fournissant un champ magnétique avec trois composantes (X-Y-Z) et avec un axe de rotation (301) alors que l'axe de rotation (301) est positionné au-dessus d'un centre du capteur AMR (200) et croise le capteur AMR (200) de manière perpendiculaire ; le capteur AMR (200) et les capteurs à effet Hall (101, 102) se trouvent dans un seul plan (900), alors que le capteur AMR (200) présente une position de mesure d'angle nul (901) indiquant une valeur de signal de zéro et détectant les composantes horizontales X et Y du champ magnétique et le premier capteur à effet Hall (101) est placé par rapport à la position de mesure d'angle nul (901) dans une plage de 0° < déphasage < 90° dans le sens antihoraire mesurant un signal qui est déphasé avec un angle croissant par rapport à la position de mesure d'angle nul du capteur AMR et le deuxième capteur à effet Hall (102) est placé par rapport à la position de mesure d'angle nul (901) dans une plage de 0° < déphasage < 90° dans le sens horaire mesurant un signal qui est déphasé avec un angle décroissant par rapport à la position de mesure d'angle nul du capteur AMR, aboutissant à un angle entre 0° et < 180° défini entre le premier capteur à effet Hall (101), un point d'intersection (302) de l'axe de rotation (301) avec le capteur AMR (200) et le deuxième capteur à effet Hall (102), alors que le traitement de signal est conçu de manière exécutable en mode analogique et/ou numérique, et alors qu'une détection d'erreur est fournie en utilisant les signaux de système de capteurs du capteur AMR et des deux capteurs à effet Hall.

2. Système de capteurs selon la revendication 1, dans lequel le capteur AMR (200), les capteurs à effet Hall (101, 102) et le circuit de traitement de signal (100) sont intégrés sur un seul substrat (400).

3. Système de capteurs selon la revendication 1, dans lequel le capteur AMR (200) comprend deux ponts intégraux (201, 202) tournés sur 45° l'un par rapport à l'autre pour détecter des composantes horizontales X et Y d'un champ magnétique généré par l'aimant rotatif.

4. Système de capteurs selon la revendication 1, dans lequel les capteurs à effet Hall (101, 102) sont mis en oeuvre autour de l'axe de rotation (301) de l'aimant rotatif (300) pour détecter une composante verticale Z d'un champ magnétique généré par l'aimant rotatif (300) .

5. Système de capteurs selon la revendication 2, dans lequel les capteurs à effet Hall (101, 102) sont intégrés dans le circuit de traitement de signal (100).

6. Système de capteurs selon la revendication 1, dans lequel les deux capteurs à effet Hall (101, 102) sont positionnés de manière axialement symétrique à la position d'angle nul (901) du capteur AMR (200).

7. Système de capteurs selon la revendication 1, dans lequel le déphasage est $\pm45°$.

8. Procédé de calcul d'un angle absolu à 360 degrés de haute précision d'un corps rotatif utilisant le système de capteurs selon les revendications 1 à 7, alors que dans une unité de traitement de signal numérique (130) un premier angle absolu est calculé par une fonction d'arc-tangente avec une période de 180 degrés mécaniques fournie par des signaux détectés (7) d'un capteur AMR (200) qui présentent un déphasage de 90° les uns par rapport aux autres et un deuxième angle absolu est calculé avec une période de 360 degrés mécaniques fournie par des signaux détectés (8) d'un premier et d'un deuxième capteur à effet Hall (101, 102), alors que des signaux numériques intermédiaires (7b, 8a, 8b) sont générés par l'unité de traitement numérique (130) selon les premier et deuxième signaux d'angle absolu calculés (7, 8, 9), alors qu'une détection d'erreur est effectuée en calculant le signal d'angle aussi bien comme une rampe linéaire continue sur 360° à partir des capteurs à effet Hall que comme une rampe linéaire continue sur 180° provenant du capteur AMR.

9. Procédé de calcul d'un angle absolu à 360 degrés de haute précision d'un corps rotatif selon la revendication 8, dans lequel un premier signal numérique intermédiaire (7b) est haut lorsque l'angle calculé à partir du capteur AMR (200) est < 180 degrés électriques, et qui est bas lorsque l'angle calculé à partir du capteur AMR (200) est $\geq$ 180 degrés électriques.

10. Procédé de calcul d'un angle absolu à 360 degrés de haute précision d'un corps rotatif selon la revendication 8, dans lequel un deuxième signal numérique intermédiaire (8a) est haut lorsque l'angle calculé du capteur à effet Hall est 0° + déphasage < angle calculé < (180° + déphasage) degrés mécaniques, et est bas dans toutes les autres positions d'angle, alors que le déphasage est compris dans la plage de $\pm0°$ et de $\pm90°$.

11. Procédé de calcul d'un angle absolu à 360 degrés de haute précision d'un corps rotatif selon la revendication 8, dans lequel un troisième signal numérique intermédiaire (8b) est bas lorsque l'angle calculé du capteur à effet Hall est (180° - déphasage) < angle calculé ≤ (360° - déphasage) degrés mécaniques, et est haut dans toutes les autres positions d'angle, alors que le déphasage est compris dans la plage de ±0° et de ±90°.

12. Procédé de calcul d'un angle absolu à 360 degrés de haute précision d'un corps rotatif selon les revendications 8 à 11, dans lequel le signal de 360° absolu de haute précision est calculé en utilisant le signal d'angle calculé du capteur AMR (200) comme des informations d'angle primaires et en additionnant ensuite 180° à l'angle de capteur AMR, en fonction des signaux numériques intermédiaires générés.

Fig. 1

Fig. 2

Fig. 3

Fig. 4

## Fig. 5

## Fig. 6

Fig. 7

Fig. 8

## Fig. 9

## Fig. 10

Fig. 11

Fig. 12

Fig. 13

Fig. 14

Fig. 15

## Fig. 16

## Fig. 17

**REFERENCES CITED IN THE DESCRIPTION**

**Patent documents cited in the description**

- US 20120223699 A1
- US 6212783 B1
- US 6707293 B2
- DE 102006060808 A1
- DE 10017061 A1
- DE 10248060 A1